# EUROPÄISCHE PATENTSCHRIFT

(11) **EP 0 938 753 B1**
(45) Veröffentlichungstag und Bekanntmachung des Hinweises auf die Patenterteilung: **04.06.2003**
(21) Anmeldenummer: 98954115.6
(22) Anmeldetag: 04.09.1998
(51) Int. Cl.: H01L 41/083, H01L 41/047

(54) **PIEZOELEKTRISCHER AKTOR MIT EINEM ELEKTRISCHEN ANSCHLUSS**
PIEZOELECTRIC ACTUATOR WITH AN ELECTRICAL CONNECTION
ACTIONNEUR PIEZOELECTRIQUE POURVU D'UNE CONNEXION ELECTRIQUE

(30) Priorität: 15.09.1997 DE 19740570
(43) Veröffentlichungstag der Anmeldung: 01.09.1999
(73) Patentinhaber: SIEMENS AKTIENGESELLSCHAFT, 80333 München (DE)
(72) Erfinder: HEKELE, Wilhelm, D-83125 Eggstätt (DE); LEWENTZ, Günter, D-93055 Regensburg (DE); RINK, Jürgen, D-92442 Wackersdorf (DE); SCHUH, Carsten, D-85598 Baldham (DE)
(86) Internationale Anmeldenummer: DE9802616
(87) Internationale Veröffentlichungsnummer: WO99014813

(56) Entgegenhaltungen:
- EP-A- 0 844 678
- US-A- 4 917 484

## Beschreibung

Die Erfindung betrifft einen piezoelektrischen Aktor mit einem elektrischen Anschluß gemäß dem Oberbegriff des Patentanspruchs 1.

Piezoelektrische Aktoren werden beispielsweise zur Ansteuerung eines Einspritzventiles verwendet. Die Herstellung und insbesondere die Kontaktierung eines piezoelektrischen Aktors, der aus einem Stapel mehrerer, einzelner piezoelektrischen Aktorelemente besteht, ist relativ aufwendig und deshalb für eine Fertigungsoptimierung von besonderer Bedeutung.

Aus DE 42 01 937 A1 ist ein piezoelektrisches laminiertes Stellglied bekannt, das in Form eines Stapels von rechteckigen Lamellen aufgebaut ist. Die einzelnen Lamellen sind über Innenelektroden kontaktiert. Die Innenelektroden sind an zwei gegenüberliegenden Seiten mit aufgeklebten Metallbändern verbunden. Die Metallbänder sind wiederum an Dünnfilm-Außenelektroden befestigt. Selbst bei Rissen in den Dünnfilm-Außenelektroden sorgen die Metallbänder für eine Spannungsversorgung der piezoelektrischen Schichten.

DE 30 40 563 A1 beschreibt einen piezoelektrischen Aktor mit Abstandshaltern zwischen Keramiklamellen des Aktors. Die Abstandshalter weisen eine Metallfolie auf, die mit Anschlußfahnen zur elektrischen Spannungsführung versehen sind. Diese Folien sind leiterförmig mit Ausschnitten zwischen den Stegen gestaltet. Diese Gestaltung dient dazu, die Federsteifigkeit herabzusetzen.

Die Aufgabe der Erfindung beruht darin, einen piezoelektrischen Aktor bereit zu stellen, dessen Anschlüsse gegen Fehlkontakte, insbesondere gegen eine Rißbildung, geschützt sind.

Die Aufgabe der Erfindung wird durch die Merkmale des Patentanspruchs 1 gelöst. Besonders vorteilhaft ist es, Ausschnitte in einer leitenden Folie vorzusehen, mit denen eine Rißbildung, insbesondere eine Ausbreitung von Rissen, unterdrückt wird.

Weitere Ausbildungen und Verbesserungen der Erfindung snd in den abhängigen Ansprüchen angegeben. Eine weitere Aufgabe der Erfindung beruht darin, eine kompakte und einfach zu handhabende Aktoreinheit bereitzustellen. Dies wird in vorteilhafter Weise dadurch erreicht, daß die Folie flächig mit dem Aktor verbunden ist.

Die Erfindung wird im folgenden anhand der Figuren näher erläutert. Es zeigen:
- Figur 1: einen piezoelektrischen Aktor mit einer Folie als elektrischen Anschluß,
- Figur 2: einen Querschnitt durch den piezoelektrischen Aktor, und
- Figur 3: eine Folie mit Ausschnitten gegen eine Rißbildung.

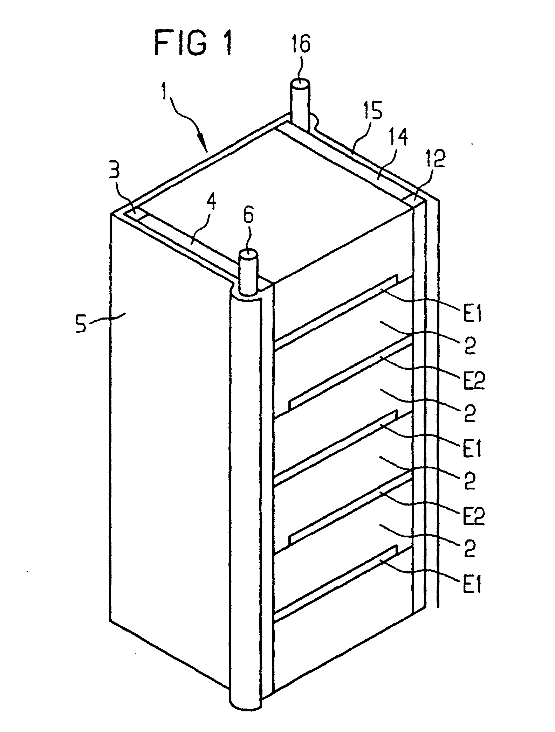

Figur 1 zeigt einen piezoelektrischen Aktor 1, der aus mehreren, übereinander gestapelten, piezoelektrischen Einzelelementen aufgebaut ist. Der Kern des Aktors 1 ist aus Elektrodenschichten E1, E2 und Keramikschichten 2 aufgebaut, die die einzelnen Aktorelemente darstellen. Der dargestellte Aktor 1 weist eine quadratische Grundfläche auf, wobei an gegenüberliegenden Ecken der Grundfläche jeweils ein Metallisierungsstreifen 3, 12 vorgesehen ist, der entlang der gesamten Länge des piezoelektrischen Aktors 1 ausgebildet ist. Der erste Metallisierungsstreifen 3 ist mit den ersten Elektrodenschichten E1 und der zweite Metallisierungsstreifen 12 ist mit den zweiten Elektrodenschichten E2 elektrisch leitend verbunden. Auf diese Weise ist eine parallele Verschaltung der einzelnen Keramikschichten 2 möglich.

Auf der Vorderseite des piezoelektrischen Aktors 1 ist der erste Metallisierungsstreifen 3 aufgebracht. Neben dem ersten Metallisierungsstreifen 3 ist zudem eine Passivierungsschicht 4 direkt auf dem Aktor 1 aufgebracht. Auf der Passivierungsschicht 4 und auf dem ersten Metallisierungsstreifen 3 ist eine elektrisch leitende erste Folie 5 vorgesehen, die flächig ausgebildet ist und im wesentlichen der Größe der Vorderseite des Aktors 1 entspricht. Durch die Passivierungsschicht 4 ist die erste Folie 5 fest mit dem piezoelektrischen Aktor 1 verbunden. Auf der ersten Folie 5 ist wiederum ein Kontaktstift 6 aufgebracht, der in Längsrichtung zum piezoelektrischen Aktor 1 angeordnet ist und entlang der vorderen, rechten Längskante gegenüberliegend zum ersten Metallisierungsstreifen 3 verläuft. Der Kontaktstift 6 ist beispielsweise als Metallstift ausgebildet und über einen Zinnstreifen mit der ersten Folie 5 elektrisch verbunden. Die erste Folie 5 ist vorzugsweise aus metallisch kaschierten Kapton hergestellt, damit eine entsprechende elektrische Leitfähigkeit gegeben ist. Die erste Folie 5 kann auch kleiner ausgebildet als die Vorderseite des Aktors 1 sein. Anstelle der Verwendung der elektrisch isolierenden Passivierungsschicht 4,14 kann die Folie 5,15 auch direkt am Aktor 1 befestigt werden, wenn die Folie 5,15 in den Bereichen, in denen die Folie 5,15 am Aktor befestigt ist, isoliert ausgeführt ist.

Auf der Rückseite des Aktors 1 ist ebenfalls ein zweiter Metallisierungsstreifen 12 und eine zweite Passivierungsschicht 14 aufgebracht. Auf der zweiten Passivierungsschicht 14 ist wiederum eine elektrisch leitende zweite Folie 15 angeordnet ist. Die zweite Folie 15 weist ebenfalls im wesentlichen die Fläche der Rückseite des Aktors 1 auf. Zudem ist auf der zweiten Folie 15 ein zweiter Kontaktstift 16 aufgebracht, der entlang der Längsseite des Aktors 1 und gegenüberliegend zum zweiten Metallisierungsstreifen 12 angeordnet ist. Somit sind die Kontaktstifte 6,16 und der erste und der zweite Metallisierungsstreifen 3, 12 jeweils diagonal zur quadratischen Grundfläche des Aktors 1 angeordnet. Durch die Passivierungsschichten 4,14 sind die Folie 5,15 fest mit dem Aktor 1 verbunden. Die zweite Folie 15 entspricht im wesentlichen im Aufbau und in der Form der ersten Folie 5.

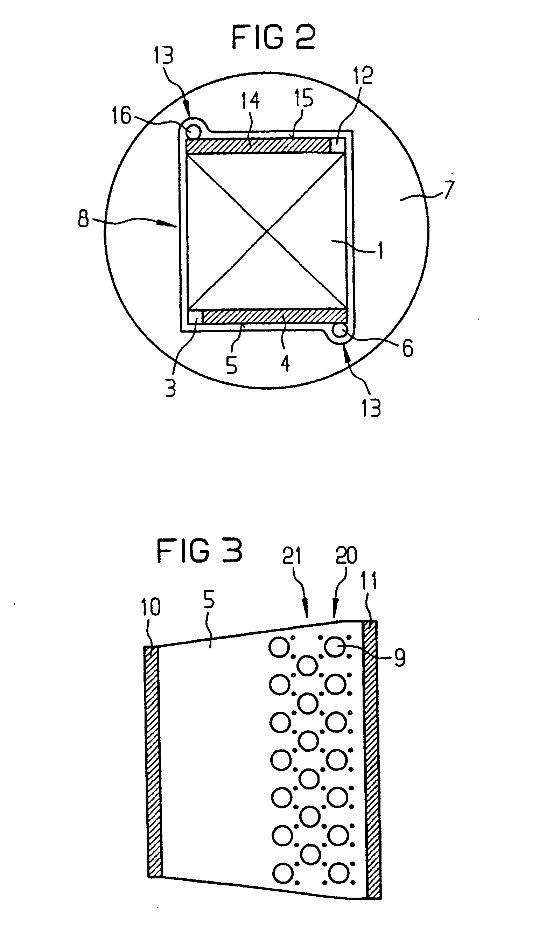

Figur 2 zeigt einen Querschnitt durch den piezoelektrischen Aktor 1, der in eine Schutzhülse 7 eingelegt ist. Die Schutzhülse 7 weist dazu eine Ausnehmung 8 auf, die im wesentlichen der quadratischen Form des piezoelektrischen Aktors 1 entspricht. Vorzugsweise sind in den Bereichen, in denen die Kontaktstifte 6,16 angeordnet sind, teilzylinderförmige Ausnehmungen 13 zusätzlich in die Schutzhülse 7 eingebracht. Die Ausnehmungen 13 erleichtern die Aufnahme des Aktors 1 mit den Kontaktstiften 6,16. Deutlich ist in Figur 2 zu erkennen, daß die Passivierungsschichten 4,14 direkt auf dem Aktor 1 aufgebracht sind und die erste und die zweite Folie 5,15 wiederum auf der Oberfläche der Passivierungsschichten 4,14 aufgebracht sind. Jeweils im Eckbereich der vorder- und der rückseitigen Seitenfläche des Aktors 1 sind der erste und der zweite Metallisierungsstreifen 3, 12 vorgesehen, der über die gesamte Länge des Aktors 1 geführt ist. Die Kontaktstifte 6,16 sind auf der Außenseite der Folien 5,15 und gegenüberliegend zum ersten bzw. zum zweiten Metallisierungsstreifen 3, 12 auf den Folie 5,15 aufgebracht. Der verbleibende Raum zwischen dem Aktor 1 und der Schutzhülse 7 ist durch eine Schutzmasse, die vorzugsweise elektrisch isolierend ist, ausgefüllt. Die Kontaktstifte 6,16 sind für eine bessere Kontaktierung nach oben über das Ende der Schutzhülse 7 herausgeführt.

Figur 3 zeigt als Beispiel für den Aufbau der Folien 5,15 eine erste Folie 5, die entlang einer Längskante eine erste Kontaktbahn 10 in Form eines Zinnstreifens für den Anschluß eines Kontaktstiftes 6 aufweist. Zudem weist die erste Folie 5 an der zweiten Längskante eine zweite Kontaktbahn 11 auf, die ebenfalls als Zinnstreifen ausgebildet ist und für die Kontaktierung der Elektroden E1 beziehungsweise E2 verwendet wird. Für ein Erschweren der Rißbildung weist die Folie 5 Ausschnitte 9 auf, die vorzugsweise im Bereich der zweiten Kontaktbahn 11 angeordnet sind. Die Form der Ausschnitte 9 ist je nach Anwendung kreisförmig, ellipsenförmig oder schlitzförmig. Die Funktion der Ausschnitte 9 beruht darin, eine Rißbildung in der Folie 5 weitgehend zu vermeiden und einen gebildeten Riß in der Ausbreitung zu stoppen. Dazu sind die Ausschnitte 9 in der Weise angeordnet, daß ein an der zweiten Kontaktbahn 11 entstehender Riß sich so wenig wie möglich ausbreitet. Vorzugsweise sind die Ausschnitte 9 in mindestens zwei Reihen 20,21 nebeneinander angeordnet, wobei die Ausschnitte 9 verschiedener Reihen 20,21 mindestens teilweise gegeneinander versetzt angeordnet sind.

Die Ausschnitte 9 der zwei Reihen 20,21 sind in der Weise angeordnet, daß sich auf einer senkrechten Verbindungslinie von der ersten zur zweiten Kontaktbahn 10,11 gesehen die Ausschnitte 9 der zwei Reihen 20,21 mindestens teilweise überlappen. Auf diese Weise wird ein Riß, der von der zweiten Kontaktbahn 11 aufgrund der Längenänderung des Aktors 1 erzeugt wird, sicher von einem Ausschnitt abgefangen. Ein durchgehender Riß wird dadurch vermieden.

Ein wesentliche Vorteil der Erfindung beruht darin, daß eine Rißbildung in der ersten oder zweiten Folie 5,15 durch die Einbringung von Ausschnitten 9 reduziert wird.

Ein weiteres wesentliches Merkmal der Erfindung beruht darin, daß die Folie 5,15 flächig auf der Passivierungsschicht 4 aufgebracht ist und damit direkt mit dem Aktor 1 flächig verbunden ist. Die Anordnung der Folie 5,15 auf dem Aktor 1 ist für sich genommen ein wesentliches und selbständiges Merkmal, das unabhängig von anderen Merkmalen wie z.B. den Ausschnitten 9 wesentliche Bedeutung hat. Die Aufbringung der Folie 5 auf einer einzigen Seitenfläche des Aktors 1, ohne über eine Kante des Aktors 1 zu führen, reduziert in vorteilhafter Weise die mechanische Belastung der Folie 5.

Die in Figur 1 dargestellte Aktoreinheit, die den Aktor 1, die Passivierungsschichten 4,14, die Folien 5,15 und vorzugsweise die Kontaktelmente 6,16 aufweist, kann mit einfachen Mitteln in die entsprechende Ausnenmung 8 einer Schutzhülse 7 eingebracht werden. Die Fixierung der Folie 5,15 auf der Passivierungsschicht 4,14 und damit auf dem Aktor 1 ermöglicht ein einfaches Handling der Aktoreinheit. Die Folie 5,15 ist dadurch gegen eine Beschädigung, z. B. beim Einbringen der Aktoreinheit in die Schutzhülse 7, gut geschützt.

Der Querschnitt der Figur 2 zeigt deutlich, daß die vorgeschlagene Art der Anordnung der Folien 5,15 auf dem Aktor eine besonders kompakte Bauform des Aktor ermöglicht. Zudem wird die Form der Ausnehmung 8 im wesentlichen auf einen geschlossenen, quadratischen Querschnitt vereinfacht.

Vorzugsweise kann die Aktoreinheit auch ohne Schutzhülse 7 nur mit einer Schutzmasse umformt werden, wobei ein Stekkeranschluß für die Kontaktstifte 6,16 sofort mitgeformt werden kann.

## Patentansprüche

1. Piezoelektrischer Aktor mit einem elektrischen Anschluß in Form einer Folie (5,15), die mindestens einen Ausschnitt (9) aufweist **dadurch gekennzeichnet, daß** mindestens der eine Ausschnitt derart gestaltet ist, daß er die Ausbreitung von Rissen in der Folie (5,15) behindert.

2. Piezoelektrischer Aktor nach Anspruch 1, **dadurch gekennzeichnet, daß** die Folie (5,15) flächig mit dem Aktor (1) verbunden ist.

3. Piezoelektrischer Aktor nach Anspruch 1 oder 2, **dadurch gekennzeichnet, daß** zwischen der Folie (5,15) und dem Aktor (1) eine Passivierungsschicht (4,14) vorgesehen ist, die die Folie (5,15) fest mit dem Aktor (1) verbindet.

4. Piezoelektrischer Aktor nach Anspruch 1 oder 2, **dadurch gekennzeichnet, daß** die Folie (5,15) auf einer Seitenfläche des Aktors (1) angeordnet ist.

5. Piezoelektrischer Aktor nach Anspruch 1, oder 2, **dadurch gekennzeichnet, daß** eine Kontaktleitung (3,12,11) entlang eines Randbereiches der Folie (5,15) angeordnet ist, die entlang eines Randbereiches einer Seitenfläche des Aktors (1) angeordnet ist, und daß die Kontaktleitung (11) mit zugeordneten Elektrodenschichten (E1,E2) des Aktors (1) elektrisch verbunden ist.

6. Piezoelektrischer Aktor nach Anspruch 1 oder 2, **dadurch gekennzeichnet, daß** entlang eines zweiten Randbereiches der Folie (5,15), der entlang eines zweiten Randbereiches der Seitenfläche des Aktors (1) angeordnet ist, ein Anschlußmittel (10,6,16) für eine elektrische Kontaktierung zur Ansteuerung des Aktors (1) vorgesehen ist.

7. Piezoelektrischer Aktor nach Anspruch 1 oder 2, **dadurch gekennzeichnet, daß** der Aktor (1) in eine Ausnehmung (8) einer Schutzhülse (7) eingebracht ist, daß der Querschnitt der Ausnehmung (8) eine geschlossene Form aufweist, und daß der Raum zwischen der Schutzhülse (7) und dem Aktor (1) mit einer Füllmasse gefüllt ist.

8. Piezoelektrischer Aktor nach Anspruch 6, **dadurch gekennzeichnet, daß** die Ausnehmung (8) an zwei diagonal gegenüberliegenden Eckbereichen halbzylinderförmige Ausnehmungen (13) aufweist, die zur mindestens teilweisen Aufname von Kontaktelementen (6,16) dienen.

9. Piezoelektrischer Aktor nach Anspruch 1 oder 2, **dadurch gekennzeichnet, daß** der Aktor (1) mit den Passivierungsschichten (4,14), mit der ersten und der zweiten Folie (5,15) und mit den Kontaktelementen (6,16) direkt mit einem Schutzmantel umformt ist.

10. Piezoelektrischer Aktor nach Anspruch 1, **dadurch gekennzeichnet, daß** die Ausschnitte (9) mindestens teilweise gegeneinander versetzt angeordnet sind.

11. Piezoelektrischer Aktor nach Anspruch 1, **dadurch gekennzeichnet, daß** die Ausschnitte (9) in mindestens zwei Reihen (20,21) angeordnet sind, wobei die Ausschnitte (9) verschiedener Reihen (20,21) mindestens teilweise gegeneinander versetzt angeordnet sind.

12. Piezoelektrischer Aktor nach Anspruch 1, **dadurch gekennzeichnet, daß** der Ausschnitt (9) kreisformig oder ellipsenförmig ausgebildet ist.

## Claims

1. Piezoelectric actuator with an electrical connection in the form of a film (5_{,} 15) which has at least one cutout (9), **characterised in that** at least one of the cutouts is designed in such a way as to prevent the propagation of tears in the film (5, 15).

2. Piezoelectric actuator according to Claim 1, **characterised in that** the film (5,15) has a flat connection with the actuator (1).

3. Piezoelectric actuator according to Claim 1 or 2, **characterised in that** a passivation layer (4,14), which permanently connects the film (5,15) and the actuator (1), is provided between the film (5,15) and the actuator (1).

4. Piezoelectric actuator according to Claim 1 or 2, **characterised in that** the film (5,15) is located on a side surface of the actuator (1).

5. Piezoelectric actuator according to Claim 1 or 2, **characterised in that** a contact line (3,12,11) is located along one edge area of the film (5,15), which is located along one edge area of a side surface of the actuator (1), and that the contact line (11) is connected electrically to the associated electrode layers (E1,E2) of the actuator (1).

6. Piezoelectric actuator according to Claim 1 or 2, **characterised in that** along a second edge area of the film (5,15), said edge area being located along a second edge area of the side surface of the actuator, a means of connection (10,6,16) is provided for establishing electrical contact in order to control the actuator (1).

7. Piezoelectric actuator according to Claim 1 or 2, **characterised in that** the actuator (1) is incorporated in a recess (8) in a protective sleeve (7), that the cross-section of the recess (8) has a closed form, and that the space between the protective sleeve (7) and the actuator (1) is filled with a filling compound.

8. Piezoelectric actuator according to Claim 6, **characterised in that** the recess (8) has semi-cylindrical shaped recesses (13) at two diagonally opposing comer areas, said recesses serving to at least partially accommodate contact elements (6,16).

9. Piezoelectric actuator according to Claim 1 or 2, **characterised in that** the actuator (1) with the passivation layers (4,14), with the first and the second film (5,15) and with the contact elements (6,16) is enclosed directly by a protective enclosure.

10. Piezoelectric actuator according to Claim 1, **characterised in that** the cutouts (9) are arranged so as to be at least partially displaced with respect to one another.

11. Piezoelectric actuator according to Claim 1, **characterised in that** the cutouts (9) are arranged in at least two rows (20,21), whereby the cutouts (9) in different rows (20,21) are arranged so as to be at least partially displaced with respect to one another.

12. Piezoelectric actuator according to Claim 1, **characterised in that** the cutout (9) is designed to be circular or ellipse-shaped.

## Revendications

1. Actionneur piézo-électrique comportant un raccordement électrique sous la forme d'une feuille (5, 15) qui présente au moins une découpe (9),
**caractérisé en ce qu'**au moins cette découpe est conçue de telle façon qu'elle empêche l'élargissement de fissures dans la feuille (5, 15).

2. Actionneur piézo-électrique suivant la revendication 1, **caractérisé en ce que** la feuille (5, 15) est reliée à plat à l'actionneur (1).

3. Actionneur piézo-électrique suivant la revendication 1 ou 2, **caractérisé en ce qu'**entre la feuille (5, 15) et l'actionneur (1), il est prévu une couche de passivation (4, 14), qui relie de façon fixe la feuille (5, 15) à l'actionneur (1).

4. Actionneur piézo-électrique suivant la revendication 1 ou 2, **caractérisé en ce que** la feuille (5, 15) est disposée sur une surface latérale de l'actionneur (1).

5. Actionneur piézo-électrique suivant la revendication 1 ou 2, **caractérisé en ce qu'**un conducteur de contact (3, 12, 11) est disposé le long dune zone de bord de la feuille (5, 15), qui est disposé le long d'une zone de bord d'une surface latérale de l'actionneur (1), et **en ce que** la conducteur de contact (11) est relié électriquement à des couches d'électrodes associées (E1, E2) de l'actionneur (1).

6. Actionneur piézo-électrique suivant la revendication 1 ou 2, **caractérisé en ce que**, le long d'une deuxième zone de bord de la feuille (5, 15), qui est disposée le long d'une deuxième zone de bord de la surface latérale de l'actionneur (1 ), il est prévu un moyen de raccordement (10, 6, 16) pour établir un contact électrique pour commander l'actionneur (1).

7. Actionneur piézo-électrique suivant la revendication 1 ou 2, **caractérisé en ce que** l'actionneur (1) est disposé dans un évidement (8) d'un manchon de protection (7), **en ce que** la section de l'évidement (8) présente une forme fermée, et **en ce que** l'espace entre le manchon de protection (7) et l'actionneur (1) est rempli d'une masse de remplissage.

8. Actionneur piézo-électrique suivant la revendication 6, **caractérisé en ce que** l'évidement (8) présente, dans deux zones d'angle diagonalement opposées, des évidements (13) en forme de demi-cylindre, qui servent à recevoir, au moins partiellement, des éléments de contact (6, 16).

9. Actionneur piézo-électrique suivant la revendication 1 ou 2, **caractérisé en ce que** l'actionneur (1), avec les couches de passivation (4, 14), avec les première et deuxièmes feuille (5, 15) et avec les éléments de contact (6, 16), est entouré directement d'une enveloppe de protection.

10. Actionneur piézo-électrique suivant la revendication 1, **caractérisé en ce que** les découpes (9) sont disposées décalées, au moins en partie, les unes par rapport aux autres.

11. Actionneur piézo-électrique suivant la revendications 1, **caractérisé en ce que** les découpes (9) sont disposées suivant au moins deux rangées (20, 21), les découpes (9) de rangées différentes (20, 21) étant disposées décalées, au moins en partie, les unes par rapport aux autres.

12. Actionneur piézo-électrique suivant la revendication 1, **caractérisé en ce que** la découpe (9) est réalisée avec une forme circulaire ou elliptique.
